# EUROPEAN PATENT SPECIFICATION

(11) **EP 1 863 080 B1**
(45) Date of publication and mention of the grant of the patent: **24.04.2013**
(21) Application number: 07000890.9
(22) Date of filing: 17.01.2007
(51) Int. Cl.: H01L 21/762

(54) **Semiconductor integrated circuits with high breakdown voltage**
Integrierte Halbleiterschaltungen mit hoher Durchschlagspannung
Circuits intégrés à semi-conducteurs avec une tension disruptive élevée

(30) Priority: 10.03.2006 JP 2006065023
(43) Date of publication of application: 05.12.2007
(73) Proprietor: HITACHI, LTD., Chiyoda-ku Tokyo 100-8280 (JP)
(72) Inventor: Honda, Mitsutoshi, Chiyoda-ku Tokyo 100-8220 (JP); Watanabe, Atsuo, Chiyoda-ku Tokyo 100-8220 (JP); Ito, Masahiro, Chiyoda-ku Tokyo 100-8220 (JP); Tabata, Toshihito, Chiyoda-ku Tokyo 100-8220 (JP); Kurita, Shinichi, Hitachi-shi Ibaraki (JP); Ishitsuka, Norio, Chiyoda-ku Tokyo 100-8220 (JP)
(74) Representative: Beetz & Partner

(56) References cited:
- EP-A- 1 180 800
- EP-A- 1 331 662
- EP-A1- 1 220 312
- US-A- 5 576 241
- US-A- 5 607 875
- US-A1- 2002 043 699

## Description

### Background of the Invention

### (1) Field of the Invention

The present invention relates to a semiconductor integrated circuit of which elements are separated by a trench, using a SOI (Silicon On Insulator or Semiconductor On Insulator) substrate, particularly to that used for an intelligent power device. A semiconductor integrated circuit according to the preamble portion of patent claim 1 is known from EP 1 220 312 A1.

### (2) Description of the Related Art

In a semiconductor integrated circuit which has an element such as a transistor or resistor formed on a SOI substrate having a semiconductor layer formed on an insulating film, high-speed switching operation below µsec order owing to reduction in parasitic capacitance or high breakdown voltage not smaller than 100 V may be realized, and high reliability may be provided due to such as absence of a latch-up phenomenon. The SOI substrate is described in Patent Document 1. In addition, a trench structure for separating an element is described.

Fig. 2 shows a trench structure for separating an element disclosed in JP 5-259266 A. Fig. 2 shows a silicon support substrate by symbol 1, a buried oxide layer by 2, an element region by 3, a buried polycrystalline silicon layer by 4, a side oxide layer by 5, 6, a trench by 7, and a buried n⁺ region by 8, and the trench 7 structurally separates the element region. Further, the buried polycrystalline silicon film 4 is disposed between the side oxide layers 5.

JP 5-259266 A scarcely describes an oxide layer to be formed on a surface of a substrate after formation of a trench 7. Voltage applied to an oxide layer formed in the trench may vary owing to an effect of potential of a polysilicon wiring portion to be formed on top of the trench, depending on a shape of the oxide layer formed on the surface of the substrate. In fact, when application of potential to the polycrystalline silicon wiring portion on the oxide layer formed on the surface and to an electrode on an element region may present a problem that voltage is not evenly applied to the side oxide layers 5, 6 formed at both ends of the trench.

Details concerning this point will be given. When the oxide layer has breakdown voltage of 300 V, the application of even voltage to the side oxide layers 5, 6 at both ends of the trench may produce breakdown voltage of 600 V in sum total. However, in the case where voltage is applied to the side oxide layer 5 higher by 10% than that to the side oxide layer 6, when uneven voltages such as voltage of 300 V to the side oxide layer 5 and voltage of 270 V to the side oxide layer 6 are applied, then dielectric breakdown occurs in an element. Therefore, breakdown voltage for the entire element may lower from 600 V to 570 V.

EP 1 220 312 A1 discloses a semiconductor integrated circuit comprising a silicon substrate, an element region formed on a surface of the silicon substrate, a first insulating film formed between the element region and the silicon substrate, a trench surrounding the element region and reaching the first insulating film, a second insulating film formed on a side wall of the trench, polycrystalline silicon buried in the trench, a third insulating film formed on the polycrystalline silicon buried in the trench, wherein a value obtained by dividing a film thickness of the third insulating film by a film thickness of the first insulating film is not smaller than 0.25,

An object of the present invention is to provide an integrated circuit configured so that voltage is applied evenly to side oxide layers formed at both ends in a trench and so that the defective fraction of manufactured integrated circuits is largely reduced.

This object is accomplished with an integrated circuit according to claim 1.

Dependent claims are directed on features of preferred embodiments of the invention.

Other objects, features and advantages of the invention will become apparent from the following description of the embodiments of the invention taken in conjunction with the accompanying drawings.

### Brief Description of the Drawings

Fig. 1 is a cross-section view of a conventional semiconductor integrated circuit;
Fig. 2 is a cross-section view of a further example of a conventional semiconductor integrated circuit;
Fig. 3 is a plain view of a semiconductor integrated circuit of Fig. 1;
Fig. 4 shows the breakdown voltage measurement result of a semiconductor integrated circuit of Fig. 1;
Fig. 5 illustrates steps of a process for manufacturing a semiconductor integrated circuit of Fig. 1;
Fig. 6 illustrates further steps of a process for manufacturing a semiconductor integrated circuit of Fig. 1;
Fig. 7 illustrates further steps of a process for manufacturing a semiconductor integrated circuit of Fig. 1;
Fig. 8 is a cross-section view of an embodiment of a semiconductor integrated circuit according to the present invention;
Fig. 9 illustrates relation between breakdown voltage and the number of a trench of a semiconductor integrated circuit of Fig. 8; and
Fig. 10 illustrates the relation between breakdown voltage and a ratio of a film thickness of an oxide layer, concerning a semiconductor integrated circuit according to the present invention.

### Description of Numerals

| | |
|---|---|
| 1, 101 | silicon support substrate |
| 2, 102 | buried oxide layer |
| 3, 103, 103a, 103b, 501, 502 | element region |
| 4, 104 | buried polycrystalline silicon film |
| 5, 6, 105 | side oxide layer |
| 7, 107 | trench |
| 8 | buried n⁺ region |
| 106 | surface oxide layer |
| 108 | n⁺ doped region |
| 109 | p-doped region |
| 110 | buried n⁺ doped region |
| 111 | side n⁺ doped region |
| 112, 403 | polycrystalline silicon wiring portion |
| 113 | p⁺ doped region |
| 114 | one side of a trench |

### Detailed Description of the Invention

A semiconductor integrated circuit of the present invention is realized by optimizing the film thickness of an oxide layer to be formed using thermal oxidization on a bottom surface, side surface and upper surface of a trench, in conformity to a rated specification of the semiconductor integrated circuit, in order that voltage may be applied evenly to the oxide layers at both ends formed on a side wall of the trench. Details will be hereinafter described in conjunction with the accompanying drawings.

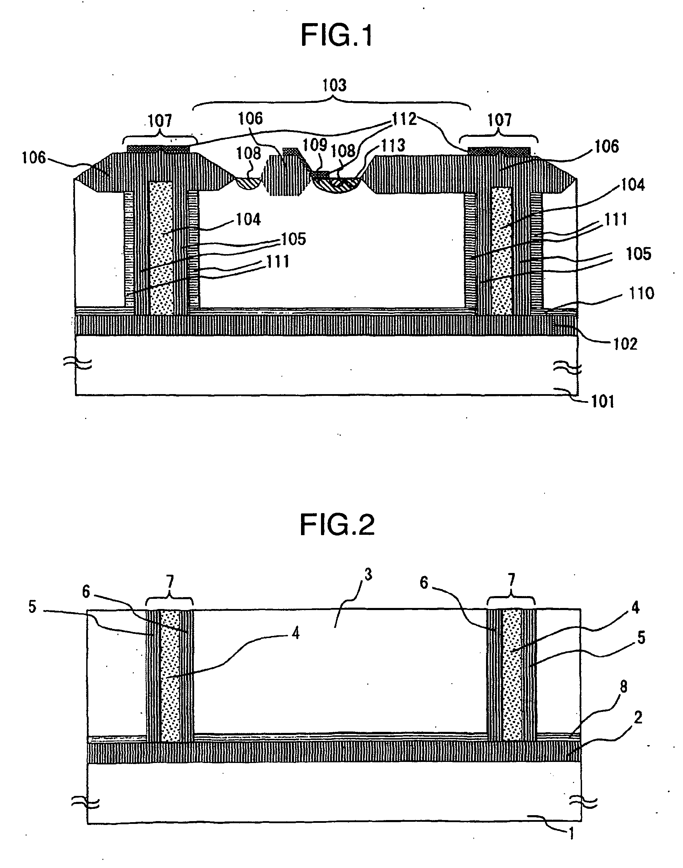

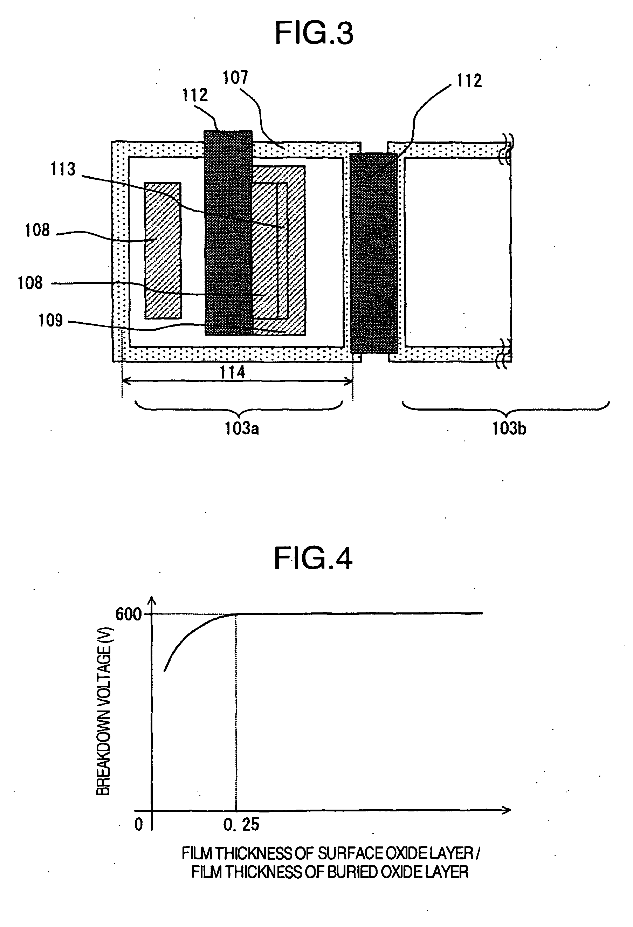

Fig. 1 is a cross-section view of a conventional semiconductor integrated circuit. In Fig. 1, a silicon support substrate is denoted by symbol 101, a buried oxide layer is by 102, an element region is by 103, a buried polycrystalline silicon film is by 104, a side oxide layer is by 105, a surface oxide layer is by 106, a trench is by 107, a n⁺ doped region is by 108, a p-doped region is by 109, a buried n⁺ doped region is by 110, a side n⁺ doped region is by 111, a polycrystalline silicon wiring portion is by 112, and a p⁺ doped region is by 113. Further, Fig. 3 is a plain view of a semiconductor integrated circuit of this example. Two element formation regions 103a and 103b are formed adjacent to each other. The polycrystalline silicon wiring portion 112 is formed to straddle the trench 107. In Fig. 3, one side of the trench is denoted by symbol 114. In this example, by thermal oxidation of a surface of the buried polycrystalline silicon film 104 buried in the trench, the surface oxide layer 106 is formed thickly on top of the trench 107, thus, structurally, voltage may be applied evenly to the side insulating films 105 formed at both ends in the trench.

The breakdown voltage is measured, with varying the film thickness of the surface oxide layer 106 of the trench and a film thickness of the buried oxide layer 102 in the range of 0.1 µm to 3 µm. Fig. 4 shows the measurement result. When a value obtained by dividing the film thickness of the surface oxide layer 106 by the film thickness of the buried oxide layer 102 becomes not smaller than 0.25, the breakdown voltage proved to be not smaller than 600 V. Studying the result, for a length of the one side 114 of the trench in the range of 200 µm to 2000 pm and a depth of the trench in the range of 50 pm to 100 pm, the breakdown voltage was not dependent on the length or depth. In addition, if the trench depth is not greater than 50 pm, the breakdown voltage largely lowered regardless of the film thickness of the surface oxide layer 106 of the trench and the film thickness of the buried oxide layer 102. From the result, it may be understood that when the value obtained by dividing the film thickness of the surface oxide layer 106 of the trench by the film thickness of the buried oxide layer 102 is set not smaller than 0.25, the breakdown voltage is improved.

Now, for the case with the value obtained by dividing the film thickness of the surface oxide layer 106 of the trench by the film thickness of the buried oxide layer 102 being 0.1, 0.2 and the case with the value being 0.5, 0.7, a place where dielectric breakdown occurs is located by cross-section observation of a wafer. About 100 wafers of the same type were prepared to study a distribution. As the result, in the case with the value obtained by dividing the film thickness of the surface oxide layer 106 of the trench by the film thickness of the buried oxide layer 102 being 0.1, 0.2, in any wafer, a breakdown place is found only in one of the side oxide layers 105 at both ends formed in the trench 107. On the contrary, in the case with the value obtained by dividing the film thickness of the surface oxide layer 106 of the trench by the film thickness of the buried oxide layer 102 being 0.5, the breakdown place is found in both of the side oxide layers 105 formed at both ends formed in the trench 107 for each wafer.

From observation of the breakdown place, it may be speculated that in the case with the value obtained by dividing the film thickness of the surface oxide layer 106 of the trench by the film thickness of the buried oxide layer 102 being not greater than 0.25, a higher voltage is applied to one of the oxide layers, and in the case with the value obtained by dividing the film thickness of the surface oxide layer 106 of the trench by the film thickness of the buried oxide layer 102 being not smaller than 0.25, a voltage is applied evenly to the side oxide layers 105 formed at the both ends of the trench 107.

From the result above, it is speculated that because in the case with the value obtained by dividing the film thickness of the buried oxide layer 106 by the film thickness of the surface oxide layer 102 being beyond 0.25, a voltage is applied evenly to the side oxide layers 105 at the both ends formed on a side wall of the trench, therefore, a semiconductor integrated circuit with high breakdown voltage may be provided.

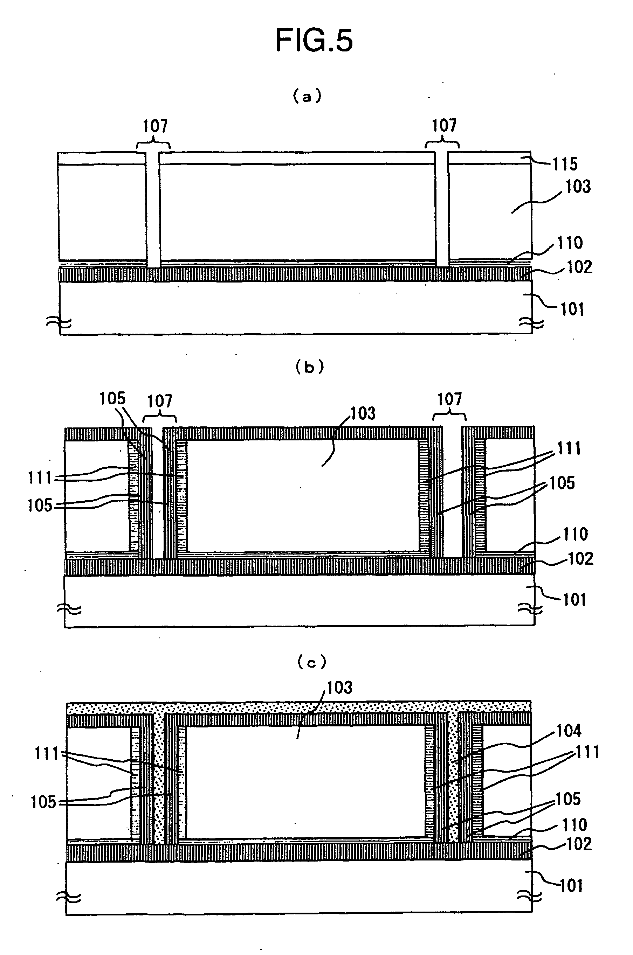

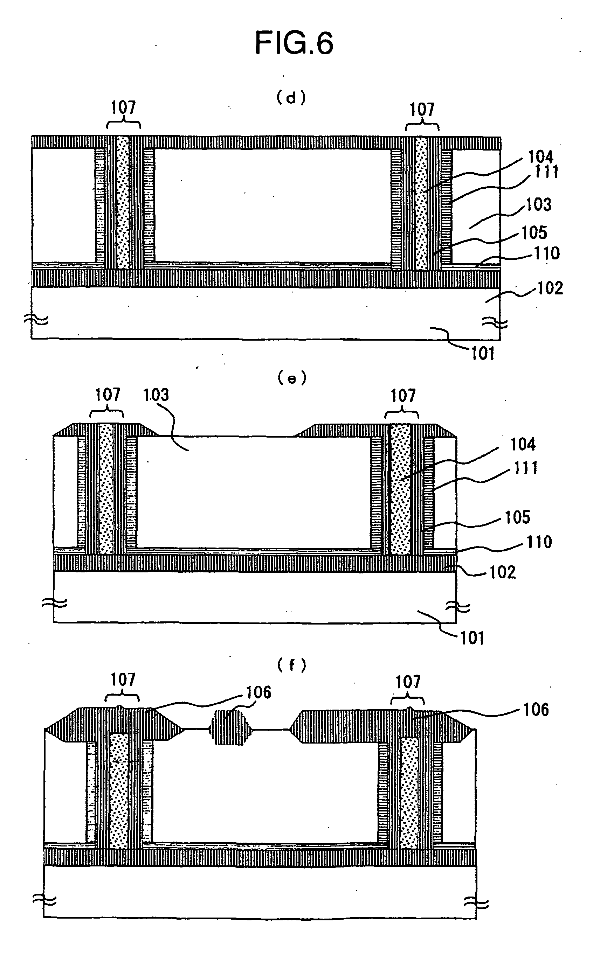

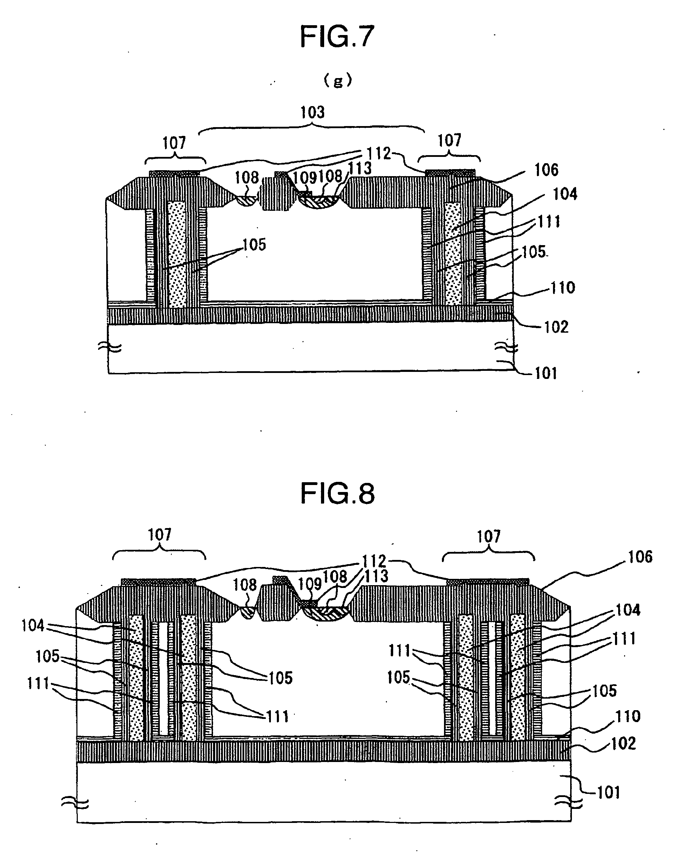

Figs. 5 to 7 show a method for manufacturing a dielectric separation substrate. Fig. 5, (a) shows a trench working process, (b) an in-groove oxidization process, and (c) a burying process of polycrystalline silicon, and in Fig. 6, (d) shows a separation and polish process, (e) a process for removing a surface oxide layer except only in a separation region including top of a trench, (f) a surface oxidization process, and in Fig. 7, (g) shows a process for creating an active element region. In Fig. 5, a photoresist is denoted by symbol 115.

A SOI substrate having the buried n⁺ doped region 110 on the buried oxide layer 102 was provided. This buried n⁺ doped region 110 was formed of arsenic or antimony. Next, as shown in Fig. 5 (a), the element region 103 was dry etched using the photoresist 115 as a mask to form the trench 107 with its depth reaching the buried oxide layer 102. After formation of the trench 107, as shown in Fig. 5 (b), the side n⁺ doped region 111 was formed by depositing antimony or phosphorous on the side wall of the trench 107, subsequently, the entire substrate was oxidized. In this process, the side oxide layer 105 is also formed in the trench 107. Then, as shown in Fig. 5 (c), the buried polycrystalline silicon film 104 was formed of polycrystalline silicon on the surface of the substrate including the trench 107. Next, as shown in Fig. 6 (d), the entire surface of the substrate was mechanically polished to leave the buried polycrystalline silicon layer 104 only in the trench 107. After mechanical polish, as shown in Fig. 6 (e), the side oxide layer 105 except in the separation region including top of the trench was etched away. Next, as shown in Fig. 6 (f), the surface oxide layer 106 was formed in the separation region including top of the trench, by a usual, local oxidization method using a silicon nitride film. Further, as shown in Fig. 7 (g), boron or phosphorous was implanted into a part of the top of the element region to form active element regions such as the n⁺ doped region 108, p-doped region 109, and p⁺ doped region 113.

In addition, in this example, upon formation of the trench, the photoresist is used as an etching mask, but not limited to this, for example, a silicon oxide layer, silicon nitride layer or laminated layer of a silicon oxide layer and silicon nitride layer may be used as the etching mask. Further, it is not necessary to form the buried layer by using the buried polycrystalline silicon layer 104, thus it may be formed by using, for example, an amorphous silicon layer.

### Example

Fig. 8 is a cross-section view of an example of a semiconductor integrated circuit. In this example, a plurality of trenches 107 were formed in the separation region. In Fig. 8, the case where the element region is surrounded by two trenches is shown, as an example. Usually, one trench may provide a rated breakdown voltage, but the use of a plurality of trenches allows a defective fraction of defect produced in the trench 107 during the manufacturing process to be reduced largely.

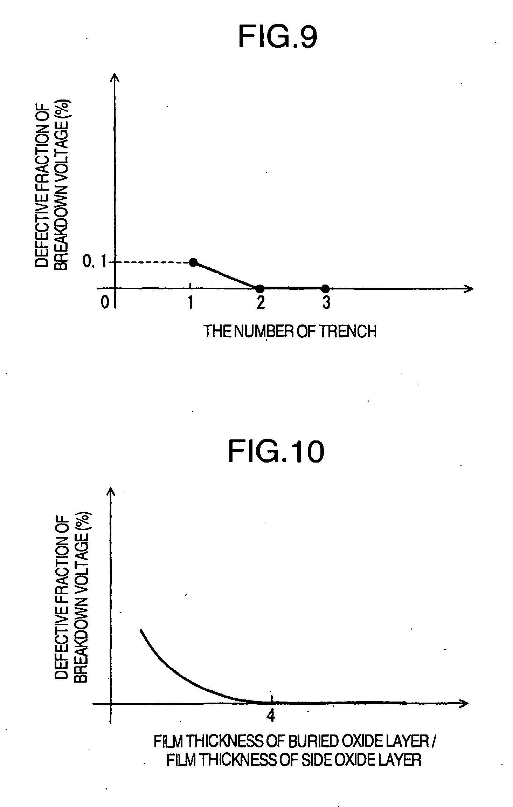

In Fig. 9, the change in the defective fraction is shown depending on the number of trenches. The breakdown voltage was measured in 2000 different integrated circuits. The defective fraction is defined as the ratio of the number of measurement points where the breakdown voltage measured is not greater than 30% of the reference value to the total number of measurement points. From this result, it can be understood that the use of a plurality of trenches, as in this example, allows a defective fraction of breakdown voltage to be reduced.

### Embodiment of the invention

A semiconductor integrated circuit of the embodiment of the invention includes a thinner film thickness of the side oxide layer 105 formed in the trench. The thinner film thickness of the side oxide layer 105 may allow stress generated in an interface between the oxide silicon and silicon upon formation of the side oxide layer to be reduced, lowering the defective fraction due to defect.

Fig. 10 shows the relation between the breakdown voltage defective fraction and the value obtained by dividing the film thickness of the buried oxide layer 102 by the film thickness of the side oxide layer 105 in the trench. When breakdown voltage is measured in 1000 different integrated circuits, the defective fraction is a rate of the number of measurement points where the breakdown voltage measured is not greater than the reference value, which is obtained by averaging the breakdown voltage measurements and multiplying the average value by 0.7. From this result, it can be understood that when the value obtained by dividing the film thickness of the buried oxide layer 102 by the film thickness of the side oxide layer 105 becomes not smaller than 4, then, the defective fraction is reduced.

For the cases with a large defective fraction, the causes of defective breakdown voltage are investigated, the defect occurring in the element region 103 having been found. From this result, it is speculated that the defect occurs in the case where the value obtained by dividing the film thickness of the buried oxide layer 102 by the film thickness of the side oxide layer 105 is small, which may provide increase in defects of breakdown voltage.

From the result above, the semiconductor integrated circuit of this embodiment has the value of not smaller than 4, which is obtained by dividing the film thickness of buried oxide layer 102 by the film thickness of the side oxide layer 105 in the trench, thereby a highly reliable semiconductor integrated circuit can be manufactured.

## Claims

1. A semiconductor integrated circuit comprising a silicon substrate (1; 101), an element region (3; 103) formed on a surface of the silicon substrate (1; 101), a first insulating film (2; 102) formed between the element region (3; 103) and the silicon substrate (1; 101), a trench (7; 107) surrounding the element region (3; 103) and reaching the first insulating film (2; 102), a second insulating film (5; 105) formed on a side wall of the trench (7; 107), polycrystalline silicon (4; 104) buried in the trench (7; 107), and a third insulating film (106) formed on the polycrystalline silicon (4; 104) buried in the trench (7; 107), wherein
a value obtained by dividing a film thickness of the third insulating film (106) by a film thickness of the first insulating film (2; 102) is not smaller than 0.25, **characterized in that**
a value obtained by dividing the film thickness of the first insulating film (2; 102) by a film thickness of the second insulating film (5; 105) is not smaller than 4.

2. The semiconductor integrated circuit according to claim 1, wherein the third insulating film (106) is an oxide layer.

3. The semiconductor integrated circuit according to claim 1, wherein a depth of the trench (7; 107) is not smaller than 50 µm.

## Patentansprüche

1. Integrierte Halbleiterschaltung mit einem Siliciumsubstrat (1; 101), einem Elementbereich (3; 103), der auf einer Oberfläche des Siliciumsubstrats (1; 101) ausgebildet ist, einer ersten isolierenden Schicht (2; 102) zwischen dem Elementbereich (3; 103) und dem Siliciumsubstrat (1; 101), einem Graben (7; 107), der den Elementbereich (3; 103) umgibt und der bis zu der ersten isolierenden Schicht (2; 102) reicht, einer zweiten isolierenden Schicht (5; 105), die auf einer Seitenwand des Grabens (7; 107) ausgebildet ist, polykristallinem Silicium (4; 104), das in den Graben (7; 107) gefüllt ist, und einer dritten isolierenden Schicht (106), die auf dem polykristallinen Silicium (4; 104), welches in den Graben (7; 107) gefüllt ist, ausgebildet ist, wobei
ein Wert erhalten durch Dividieren einer Schichtdicke der dritten isolierenden Schicht (106) durch eine Schichtdicke der ersten isolierenden Schicht (2; 102) nicht kleiner als 0,25 ist,
**dadurch gekennzeichnet, dass**
ein Wert erhalten durch Dividieren der Schichtdicke der ersten isolierenden Schicht (2; 102) durch eine Schichtdicke der zweiten isolierenden Schicht (5; 105) nicht kleiner als 4 ist.

2. Integrierte Halbleiterschaltung nach Anspruch 1, wobei die dritte isolierende Schicht (106) eine Oxidschicht ist.

3. Integrierte Halbleiterschaltung nach Anspruch 1, wobei die Tiefe des Grabens (7; 107) nicht kleiner als 50 µm beträgt.

## Revendications

1. Circuit intégré à semi-conducteurs comprenant un substrat de silicium (1 ; 101), une région d'élément (3 ; 103) formée sur une surface du substrat de silicium (1 ; 101), un premier film d'isolation (2 ; 102) formé entre la région d'élément (3 ; 103) et le substrat de silicium (1 ; 101), une tranchée (7 ; 107) entourant la région d'élément (3 ; 103) et atteignant le premier film d'isolation (2 ; 102), un deuxième film d'isolation (5 ; 105) formé sur une paroi latérale de la tranchée (7 ; 107), du silicium polycristallin (4 ; 104) noyé dans la tranchée (7 ; 107), et un troisième film d'isolation (106) formé sur le silicium polycristallin (4 ; 104) noyé dans la tranchée (7 ; 107), dans lequel
une valeur obtenue en divisant une épaisseur de film du troisième film d'isolation (106) par une épaisseur de film du premier film d'isolation (2 ; 102) n'est pas plus petite que 0,25, **caractérisé en ce que**
une valeur obtenue en divisant l'épaisseur de film du premier film d'isolation (2 ; 102) par une épaisseur de film du deuxième film d'isolation (5 ; 105) n'est pas plus petite que 4.

2. Circuit intégré à semi-conducteurs selon la revendication 1, dans lequel le troisième film d'isolation (106) est une couche d'oxyde.

3. Circuit intégré à semi-conducteurs selon la revendication 1, dans lequel une profondeur de la tranchée (7 ; 107) n'est pas plus petite que 50 µm.
